# EUROPEAN PATENT SPECIFICATION

(11) **EP 2 459 626 B1**
(45) Date of publication and mention of the grant of the patent: **25.09.2013**
(21) Application number: 10735219.7
(22) Date of filing: 23.07.2010
(51) Int. Cl.: C08J 7/04, C08J 7/14, C08J 7/16

(54) **PROTECTIVE LAYERS SUITABLE FOR APPLICATION AS BACK SHEETS FOR PHOTOVOLTAIC MODULES**
SCHUTZSCHICHTEN ZUM AUFTRAGEN ALS RÜCKSEITIGE FOLIEN FÜR PV-MODUILE
COUCHES PROTECTRICES APPROPRIÉES POUR UNE APPLICATION EN TANT QUE FEUILLES ARRIÈRE POUR MODULES PHOTOVOLTAÏQUES

(30) Priority: 27.07.2009 IT VI20090192
(43) Date of publication of application: 06.06.2012
(73) Proprietor: Coveme S.P.A., 34170 Gorizia (IT)
(72) Inventor: D'ARCO, Luigi, 34070 Monfalcone (GO) (IT); GALETTI, Gianni, 40055 Castenaso (BO) (IT)
(74) Representative: Grünecker, Kinkeldey, Stockmair & Schwanhäusser
(86) International application number: PCT/EP2010/004545
(87) International publication number: WO 2011/012275

(56) References cited:
- EP-A1- 1 930 953
- EP-A2- 0 329 417
- DE-A1- 19 952 323

## Description

### FIELD OF THE PRESENT INVENTION

The present invention relates to the field of protective layers. In particular, the present invention relates to a process for producing protective layers and to protective layers obtainable with said process. Still more in particular, the present invention relates to a process for producing protective layers suitable for application as back sheets in the field of photovoltaic modules.

### STATE OF THE ART

Solar cells are used to convert sunlight into electrical energy by the photovoltaic effect. Solar cells represent, therefore, one of the most promising sources of alternative energy intended to replace fuel sources. They are built of semiconductor materials and they are assembled to form the so called photovoltaic modules which, in turn, are grouped to form the photovoltaic arrays typically installed on rooftops or the like.

In order to form photovoltaic modules, groups of solar cells are usually encapsulated by encapsulating materials such as Ethylene-vinyl acetate (EVA). The encapsulating material sealing the solar cells is then sandwiched between a surface layer and a back sheet completing the photovoltaic module. The surface layer, or primary surface of the module, usually made of glass or of thermoplastic materials, covers the surface of the module exposed to the sun and allows the sunlight to reach the cells. The back sheet, on the other hand, performs a multiplicity of tasks. It ensures protection for the encapsulation material and the solar cells from environmental effects. In particular, the back sheet prevents moisture, oxygen and weather related factors to damage the encapsulating material and the cells. It provides electrical insulation for the cells and the corresponding electrical wiring. Moreover, the back sheet allows increasing the mechanical strength of the module and protecting the encapsulation material and the cells from mechanical damages. Furthermore, the back sheet must exhibit high opacity for aesthetical purposes and high reflectivity for functional purposes.

One of the materials most commonly employed for the formation of back sheets for photovoltaic modules is Polyvinyl fluoride (PVF) or Tedlar®. This material, although resistant to water and to several atmospheric and chemical agents, allows humidity to diffuse through it and, therefore, it is not ideal to protect the components behind as well as the adhesive layers from moisture related problems and it does not ensure a sufficient electrical insulation level if used as a single layer backsheet. For this reason, usually, the back sheets are formed as multilayer structures with a polyester sheet as moisture barrier and electrical insulation sandwiched between two PVF sheets attached to the polyester by means of adhesive substances. In this case, the PVF sheets protect the polyester sheet from UV radiation. Nevertheless, humidity diffusing through the PVF sheet may damage the adhesive layers and the polyester layer. Moreover, Tedlar® is characterized by limited availability and high costs increasing therefore the costs related to the production of photovoltaic modules and degrading the cost per watt ratio of the system.

In order to reduce the quantity of Tedlar® necessary for the formation of back sheets for photovoltaic modules, the so called TPE approach has been attempted employing one single layer of Tedlar®, a sheet of polyester and a layer of EVA. Alternatively, a PPE approach has been attempted employing a double layer of polyester on a layer of EVA. Nevertheless, in both cases, adhesive substances have been employed to adhere the layers to each other, in particular to effectively adhere the polyester to the EVA. However, these substances are strongly damaged by UV radiation and by moisture, in particular by hydrolysis mechanism, thereby reducing the lifetime of the photovoltaic modules.

Alternative solutions are known from the prior art having in common the employment of fluoropolymers for the formation of protective films. One of the main problems connected with the employment of fluoropolymers is to achieve a stable and lasting bonding between the fluoropolymer film and the polyester.

Document US 2007/0154704 A1 describes a fluoropolymer coated film for photovoltaic modules comprising polymeric substrate film and fluoropolymer coating on the polymeric substrate film. In order to promote bonding of the fluoropolymer coating to the substrate film, adhesive substances such as compatible adhesive polymers are employed. The adhesive is embedded into the coating and the polymeric film surface must be pretreated.

Document US 2008/0264484 A1 describes a liquid coatings application technology followed by lamination with EVA in order to obtain a back sheet comprising a layer of fluoropolymers without employing adhesive substances. Nevertheless, the technique described in this document is based on the employment of strong solvents that represent several drawbacks related to health hazards problems and to disposal and environmental issues.

Document CA 2611594 A1 describes a method for producing laminates for encapsulating solar cell systems wherein at least one weather-resistant plastic layer comprising fluoropolymers is applied on a carrier material. The carrier material is pretreated by application of additional adhesive substances or of an inorganic oxide layer such as a silicon oxide layer. Moreover, the fluoropolymers are dispersed in solvents solutions. Also this solution, therefore, is characterized by the drawbacks related to the presence of adhesive substances easily degraded by humidity and UV radiation and to the employment of strong solvents.

A further problem related to back sheets for photovoltaic modules comprising polyester layers concerns the tendency of the polyester sheets to contract when heated. When the polyester layer contracts under the effect of the external temperature, the bonding to the adjacent layers is damaged and the module degrades undergoing a sort of exfoliation process.

Document DE 199 52 323 A1 discloses protective sheets for solid materials such as plastics, metals, glass, wood, ceramic or paper, in order to prevent scratching of said materials and to render their surfaces anti-adhesive. DE 199 52 323 A1 does not disclose back sheets for photovoltaic modules. Moreover, according to DE 199 52 323 A1 (col. 2, lines 18 - 28), the composition of the protective sheet comprises a solution comprising: 50 to 80 percent by weight of amino functionalized silica gel, 10 to 50 percent by weight of unsaturated vinyl monomer, 0.1 to 20 percent by weight carboxylic esters containing fluoride and 0.1 to 5 percent by weight of a promoter such as organic peroxides or azo compounds. Such a solution is dispersed on a polyester sheet (example 3, col. 4), on a polycarbonate sheet (example 4, col. 4), on a poly methyl-methacrylate plate (example 5, col. 4) or on polished steel or aluminum (example 6, col. 5). According to example 3, the dispersed solution is dried in air and finally cured for 45 minutes at 85° C. The bonding between the dispersed solution and the substrate in the systems described in DE 199 52 323 A1 is not stable and lasting. Accordingly, such a system tends to exfoliate and to exhibit a short lifetime. In particular, extreme weather conditions, such as those a photovoltaic module is typically exposed to, would rapidly deteriorate a system such as one of those described in DE 199 52 323 A1. For these reasons, the systems described in DE 199 52 323 A1 are not suitable for applications as back sheets photovoltaic modules.

Document EP 0 329 417 A2 discloses a process for improving the adhesion to polyacetal articles. In particular, document EP 0 329 417 A2 relates to polyacetals (polyoxymethylenes) which can be used as substitute for metals in certain automobile parts. The polyacetal articles according to EP 0 329 417 A2 are prepared reinforcing glass fibers by means of polyacetal resins. EP 0 329 417 A2 does not describe sheets but polyacetal articles used in certain automobile parts. Moreover, EP 0 329 417 A2 does not describe protective sheets and, more in particular, EP 0 329 417 A2 does not describe protective sheets suitable as back sheets for photovoltaic modules. The chemical systems described in EP 0 329 417 A2 are, in fact, completely different from the systems employed as back sheets for photovoltaic modules. The chemical systems described in EP 0 329 417 A2 are not suitable to be employed as protective sheets, and they are not suitable to withstand atmospheric agents.

### OBJECT OF THE PRESENT INVENTION

In view of the cited problems and drawbacks relating to the formation of back sheets for photovoltaic modules, it is an object of the present invention to provide back sheets for photovoltaic modules and a method of producing same allowing to overcome said problems.

In particular, it is an object of the present invention to provide back sheets for photovoltaic modules that are stable even in the presence of extreme weather conditions and that display an extremely low degrade rate and long lifetime. In particular, it is an object of the present invention to provide back sheets for photovoltaic modules exhibiting optimum resistance properties against both moisture and UV radiation. Moreover, it is an object of the present invention to provide inexpensive back sheets for photovoltaic modules. It is a further object of the present invention to provide stable back sheets for photovoltaic modules without employing adhesive substances to bond the layers, at least for the layers mainly subject to weather conditions such as the external ones. Moreover, it is a further object of the present invention to provide back sheets for photovoltaic modules without fluoropolymers so as to have materials easy to recycle and/or to dispose at the end of life of the product. It is a further object of the present invention to provide a solvent free method for the production of back sheets for photovoltaic modules. It is a further object of the present invention to provide back sheets for photovoltaic modules comprising polyester layers wherein no contraction of the polyester layers occurs under the effect of the external temperature.

### BRIEF DESCRIPTION OF THE INVENTION

According the present invention there is provided a method for producing protective sheets, preferably back sheets for photovoltaic modules, which is based on the novel and inventive concept of pre-treating the surface of an internal layer of the protective sheet by chemical etching followed by deposition, on at least one treated surface, of an aqueous dispersion of self cross linkable materials and by subsequent reticulation of said dispersion on the pre-treated surface as defined in claim 1.

Preferred embodiments are given in the subclaims as well as in the following specification.

The present invention further provides the protective sheets, preferably back sheets for photovoltaic modules, as defined in claims 9 and 10 and in the following specification.

The present invention provides, moreover, the photovoltaic module as defined in claim 11 and in the following specification.

### BRIEF DESCRIPTION OF THE DRAWINGS

Figure 1 schematically shows a sectional view of the layers forming a protective sheet according to a preferred embodiment of the present invention.
Figure 2 schematically shows a sectional view of the application of a protective sheet as shown in Figure 1 as back sheet for a photovoltaic module.
Figure 3 schematically shows the process for forming a protective layer according to a preferred embodiment of the present invention.
Figure 4 schematically shows the process for forming a back sheet for a photovoltaic module according to a further preferred embodiment of the present invention.

### DETAILED DESCRIPTION

In the following, the present invention is described with reference to particular embodiments as shown in the enclosed drawings. Nevertheless, the present invention is not limited to the particular embodiments described in the following detailed description and shown in the figures, but, instead, the embodiments described simply exemplify several aspects of the present invention, the scope of which is defined by the appended claims.

Further modifications and variations of the present invention will be clear for the person skilled in the art. Therefore, the present description has to be considered as including all the modifications and/or variations of the present invention, the scope of which is defined by the appended claims.

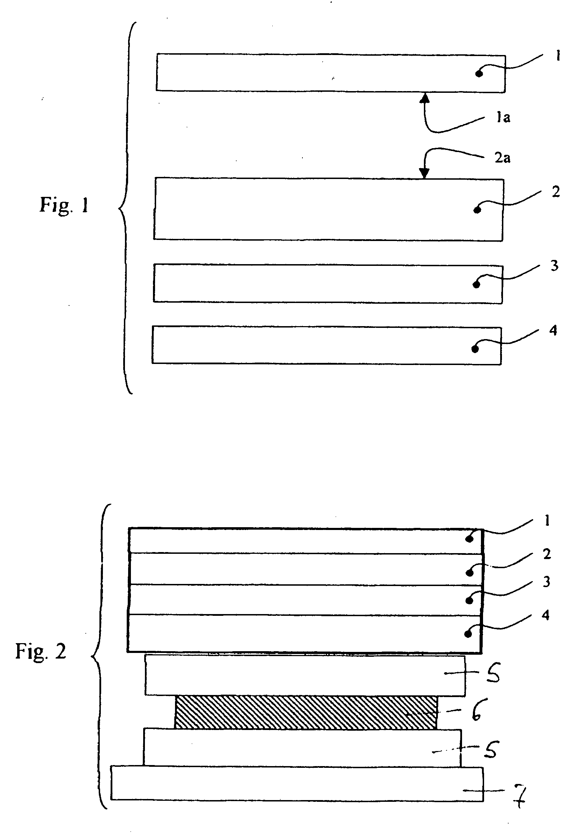

Figure 1 schematically shows a sectional view of the layers forming a back sheet for a photovoltaic module according to a preferred embodiment of the present invention. Layer 1 is the external layer of the back sheet: it is placed at the air side of the module and it is directly exposed to air. Layer 2 is the second layer of the back sheet and it is an internal layer. Reference number 1a refers to the internal surface of the external layer 1. Reference number 2a relates to the surface of the layer 2 which is to be bound with the surface 1 a of the external layer 1. Element 3 represents an intermediate adhesive element. Layer 4 is a layer with primer functionality, it can be of the same nature of the encapsulant used to encapsulate the cells and it is placed at the inner side of the back sheet toward the photovoltaic cells.

Layer 2 may be a polyester layer as preferable solution for the application as back sheet for photovoltaic cells. In order to optimize the bonding of the layer 2 with the layer 1, the surface 2a of the layer 2 is chemically modified by an etching process. In particular, the surface 2a is modified by using a water based solution of trichloroacetic acid (TCA) and silica particles. In general, any solvent dispersion of silica particles containing a wetting agent and one or more chloro-substituted organic acids from the group of trichloroacetic, tricloropropionic and dichloroacetic acid can be employed for this purpose as described, for instance, in US 3,396,046. The presence of silica particles in the solution improves the mechanical grip of the surface 2a on the layer 1.

This etching process is performed in a temperature range between 40°C and 180°C.

The next step concerns the formation of the layer 1 on the internal layer 2 pretreated with the etching process as described above. The layer 1 is formed by deposition on the etched surface 2a of the layer 2 of a water based dispersion of self cross linkable material followed by a cross linking reaction of said material.

A first example of suitable water based dispersion of self cross linkable material is represented by acrylic resins dispersed in aqueous solution preferably catalyzed by an acid catalyst.

Examples of suitable self cross linkable resins are acrylic resins having in their structure an hydroxyl functionality (HEMA) and an N-methyol methacrylamide (N-MMAA) or glycidyl methacrylate (GMA). Further examples of suitable self cross linkable acrylic polymers may be found also in patents US 4,810,751 and US 4,473,678.

Further examples of suitable acrylic water and solvent soluble resins are polymethyl acrylate (PMA) and butyl meta acrylate (BMA) having in their structure hydroxyl functionality (HEMA) that can react with conventional cross linker such as hexamethylene diisocyanate (HDI).

Further examples of suitable self cross linkable resins and of the processes for preparing same may be found in EP 0 559 186 B1.

Moreover, further examples of suitable self cross linkable acrylic polymers may be found also in EP 0 508 536 A1.

An acid catalyst may be employed to improve the cross-linking reaction mechanisms. An example of acid catalyst is phosphoric acid.

Moreover, in order to improve the functionalities of the layer 1, TiO₂ may be added to the dispersion. In particular, TiO₂ is employed as whitening material and for further stabilizing and protecting the resin, in particular for acting as a filter for UV radiation.

The cross linking reaction is performed in a temperature range of 110°C - 160°C. Preferably, the reaction is performed at 150°C.

A second example of suitable water based dispersion of self cross linkable material is represented by colloid dispersions, in particular dispersions of colloidal silica. Preferably, the silica particles have a diameter in the range between 5 nm and 25 nm.

Also in this case the dispersion of colloidal silica particles may be added with TiO₂ particles for stabilizing and protecting the system, in particular for conferring the system the required UV filtering properties.

Moreover, to plasticize the system, it is possible to add polymers to the dispersion. An example of plasticizer is a poly vinyl alcohol (PVOH) water soluble having medium degree of saponification.

The thickness of the layer 1 formed by a dispersion of colloidal silica particles is in the range of the micrometers. In particular, the thickness may range from 10 µm to 20 µm. The content of TiO₂ particles depends on the thickness of the layer. For thin layers, the concentration of TiO₂ has to be increased in order to achieve the necessary UV filtering properties.

In this case, the cross linking is a silanol poly condensation that leads to an irreversible condensation of the particles of the inorganic binder that occurs when the colloidal silica is dried, i.e. reticulated. In this case, preferably, the coating is dried at temperatures higher than 130° C.

In both cases, several kinds of pigments may be added to the dispersion in order to give the layer 1 any desired color.

Layer 3 is an adhesive layer that bonds together the internal side of the layer 2 (i.e. the side of the layer 2 facing towards the cells) with the primer layer 4.

An example of such adhesive is a polyurethane two components system where the co-reactant is a diisocyanate aliphatic or aromatic.

The primer layer 4 is preferably a polyolefin film where the side that has to be bonded with the layer 3 is preferably corona treated prior to the lamination.

An example of such polyolefin film is a poly ethylene vinyl acetate having a low percent of vinyl acetate.

Figure 2 schematically shows a sectional view of the application of a back sheet as shown in Figure 1 to a photovoltaic module. In particular, the layer 4 is bound to the encapsulating material 5 sealing the solar cell 6 during a lamination process allowing the layers 4 and 5 melting together. Moreover, the figure displays the primary surface 7 of the module exposed to sunlight and generally made of glass or thermoplastic materials.

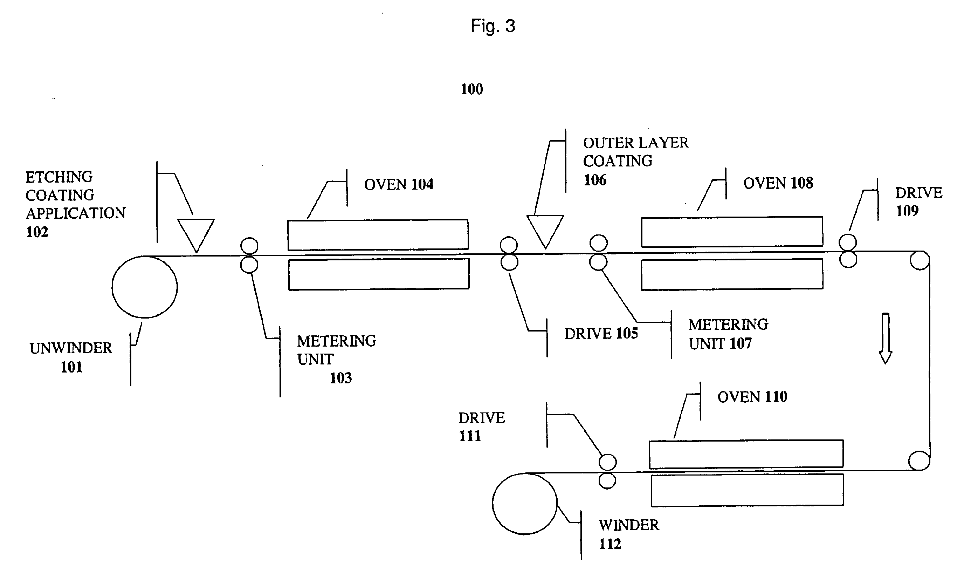

Figure 3 schematically shows the process for forming a protective layer according to a preferred embodiment of the present invention along a manufacturing line 100.

An unwinder 101 provides the line 100 with a sheet of polyester. A water based solution of trichloroacetic acid (TCA) and silica particles is applied to one of the surfaces of the sheet of polyester at the station 102 of the line 100. Afterward, the sheet of polyester whose surface is covered by the solution of TCA and silica particles reaches the oven 104 where the etching process of the surface is performed in a temperature range between 40°C and 180°C. With reference to figure 1, the sheet obtained from the oven 104 comprises the layer 2 with the etched surface 2a.

A water dispersion of self cross linkable material is then applied on the etched surface obtained in the oven 104 at the station 106 of the line 100. The oven 108 is employed for the cross linking reaction of the self cross linkable material deposited on the etched surface. The oven 108 operates preferably in a temperature range between 110°C and 160°C. However, in case a dispersion of colloidal silica is employed as self cross linkable material, the oven may operate at temperatures higher than 130°C.

The oven 110 is employed to perform a thermo-stabilization process of the sheet obtained from the oven 108. In particular, the oven 110 preferably operates in a temperature range between 160°C and 200°C.

This process allows the polyester sheet to contract so as to avoid the contraction process once the back sheet is realized. In fact, the coated and pre-contracted sheet of polyester may be then employed for the formation of the back sheet as described above. Thanks to the thermo-stabilization process of the polyester layer, the final back sheet is not subjected to exfoliation processes under the effect of the external temperature.

The protective sheet obtained from the oven 110 is finally collected by the winder 112. With reference to figure 1, the protective sheet collected by the winder 112 comprises the layers 1 and 2 bonded to each other at the surfaces 1a and 2a, respectively.

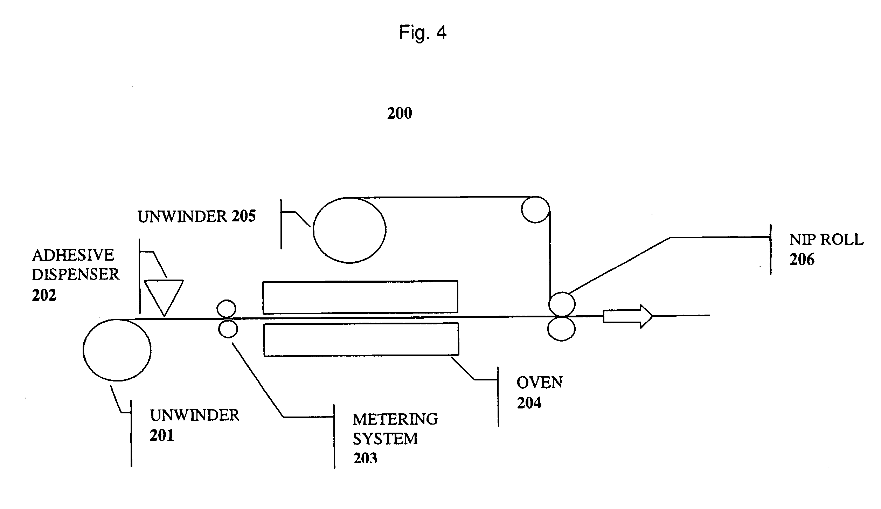

Figure 4 schematically shows the process for forming a back sheet for a photovoltaic module according to a further preferred embodiment of the present invention along a manufacturing line 200.

The unwinder 201 provides the line 200 with a protective sheet comprising an internal layer comprising an etched surface and an external layer adhered to the etched surface of the internal layer, the external layer comprising a reticulated self cross linkable material.

In a preferred embodiment of the present invention the unwinder 201 may be coupled to the winder 112 of figure 3.

At the station 202 of the line 200, an adhesive substance is deposited on the surface of the protective sheet opposite to the etched surface adhered to the reticulated self cross linkable material.

The oven 204 operates in a temperature range between 90°C and 130°C in order to evacuate the solvent present in the adhesive substance. With reference to figure 1, the protective sheet obtained from the oven 204 comprises the layer 2 bonded at one side with the layer 1 and, at the other side, with the layer 3.

The unwinder 205 provides the line 200 with a sheet of primer material. For example, the unwinder 205 may provide the line with a sheet of corona pre-treated polyolefin film.

The sheet of primer material provided by the unwinder 205 and the sheet obtained from the oven 204 are adhered to each other by the nip roll 206.

With reference to figure 1, the sheet obtained from the nip roll 206 comprises the adhering layers 1, 2, 3 and 4.

The above detailed description concerns methods for the production of protective sheets, preferably back sheets for photovoltaic modules. Nevertheless, the present invention has to be understood as including also the protective sheets as such.

## Claims

1. Method for the production of a protective sheet, preferably a back sheet for a photovoltaic module,
**characterized in that**:
said method comprises the following steps:
chemical etching of a surface (2a) of a polyester layer (2);
depositing on the etched surface (2a) a water based dispersion of self cross linkable material;
cross linking reaction of said water based dispersion of self cross linkable material deposited on said etched surface (2a).

2. Method according to claim 1,
**characterized in that**:
said chemical etching is performed by a water dispersion of silica particles containing a wetting agent and one or more chloro-substituted organic acids.

3. Method according to one of claims 1 or 2,
**characterized in that**:
TiO₂ particles are further dispersed in said water based dispersion of self cross linkable material.

4. Method according to one of claims 1 to 3,
**characterized in that**:
pigments are added to said water based dispersion of self cross linkable material in order to obtain protective sheets of different colors.

5. Method according to one of claims 1 to 4,
**characterized in that**:
said water based dispersion of self cross linkable material comprises acrylic resins dispersed in aqueous solution.

6. Method according to one of claims 1 to 4,
**characterized in that**:
said water based dispersion of self cross linkable material comprises a dispersion of silica colloidal particles.

7. Method according to one of claims 1 to 6,
**characterized in that**:
said method further comprises the step of thermo-stabilizing said polyester layer (2) after said cross linking reaction.

8. Method according to one of claims 1 to 7,
**characterized in that**:
said method further comprises:
depositing an adhesive layer (3) on the surface of said polyester layer (2) opposite to said etched surface (2a);
adhering a primer layer (4) to said polyester layer (2) through said adhesive layer (3).

9. Protective sheet, preferably a back sheet for a photovoltaic module, **characterized in that**:
said protective sheet is obtainable by one of the methods of claims 1 to 8.

10. Protective sheet, preferably a back sheet for a photovoltaic module, **characterized in that**:
said protective sheet comprises
an internal polyester layer (2) comprising an etched surface (2a); and
an external layer (1) adhered to said etched surface (2a) of said internal polyester layer (2), said external layer (1) comprising a reticulated self cross linkable material.

11. Photovoltaic module
**characterized in that**:
said photovoltaic module comprises a back sheet according to one of claims 9 or 10.

## Patentansprüche

1. Verfahren zum Herstellen einer schützenden Folie, vorzugsweise einer Rückseitenfolie für ein Photovoltaikmodul,
**dadurch gekennzeichnet, dass**:
das Verfahren die folgenden Schritte umfasst:
chemisches Ätzen einer Fläche (2a) einer Polyesterschicht (2);
Aufbringen einer Dispersion auf Wasserbasis aus selbstvernetzendem Material auf die geätzte Fläche (2a);
Vernetzungsreaktion der auf die geätzte Fläche (2a) aufgebrachten Dispersion auf Wasserbasis aus selbstvernetzendem Material.

2. Verfahren nach Anspruch 1,
**dadurch gekennzeichnet, dass**:
das chemische Ätzen mit einer Wasserdispersion aus Silikateilchen durchgeführt wird, die ein Benetzungsmittel und eine oder mehrere chlorsubstituierte organische Säure/n enthält.

3. Verfahren nach einem der Ansprüche 1 oder 2,
**dadurch gekennzeichnet, dass**:
des Weiteren TiO₂-Teilchen in der Dispersion auf Wasserbasis aus selbstvernetzendem Material dispergiert sind.

4. Verfahren nach einem der Ansprüche 1 bis 3,
**dadurch gekennzeichnet, dass**:
der Dispersion auf Wasserbasis aus selbstvernetzendem Material Pigmente zugesetzt werden, um schützende Folien unterschiedlicher Farben zu erhalten.

5. Verfahren nach einem der Ansprüche 1 bis 4,
**dadurch gekennzeichnet, dass**:
die Dispersion auf Wasserbasis aus selbstvernetzendem Material Acrylharze umfasst, die in wässriger Lösung dispergiert sind.

6. Verfahren nach einem der Ansprüche 1 bis 4,
**dadurch gekennzeichnet, dass**:
die Dispersion auf Wasserbasis aus selbstvernetzendem Material eine Dispersion aus Silika-Kolloidteilchen umfasst.

7. Verfahren nach einem der Ansprüche 1 bis 6,
**dadurch gekennzeichnet, dass**:
das Verfahren nach der Vernetzungsreaktion des Weiteren den Schritt des thermischen Stabilisierens der Polyesterschicht (2) umfasst.

8. Verfahren nach einem der Ansprüche 1 bis 7,
**dadurch gekennzeichnet, dass**:
das Verfahren des Weiteren umfasst:
Aufbringen einer Klebeschicht (3) auf die der geätzten Fläche (2a) gegenüberliegenden Fläche der Polyesterschicht (2);
Ankleben einer Grundierungsschicht (4) an der Polyesterschicht (2) über die Klebeschicht (3).

9. Schützende Folie, vorzugsweise eine Rückseitenfolie für ein Photovoltaikmodul, **dadurch gekennzeichnet, dass**
die schützende Folie mit einem der Verfahren der Ansprüche 1 bis 8 gewonnen werden kann.

10. Schützende Folie, vorzugsweise eine Rückseitenfolie für ein Photovoltaikmodul,
**dadurch gekennzeichnet, dass**
die schützende Folie umfasst:
eine innere Polyesterschicht (2), die eine geätzte Fläche (2a) umfasst; und
eine äußere Schicht (1), die an der geätzten Fläche (2a) der inneren Polyesterschicht (2) angeklebt ist, wobei die äußere Schicht (1) ein retikuläres selbstvernetzendes Material umfasst.

11. Photovoltaikmodul,
**dadurch gekennzeichnet, dass**:
das Photovoltaikmodul eine Rückseitenfolie nach einem der Ansprüche 9 oder 10 umfasst.

## Revendications

1. Procédé de fabrication d'une feuille protectrice, de préférence une feuille arrière pour un module photovoltaïque,
**caractérisé en ce que** :
ledit procédé comprend les étapes suivantes :
gravure chimique d'une surface (2a) d'une couche de polyester (2) ;
dépôt sur la surface gravée (2a) d'une dispersion aqueuse de matériau auto-réticulable ;
réaction de réticulation de ladite dispersion aqueuse de matériau auto-réticulable déposée sur ladite surface gravée (2a).

2. Procédé selon la revendication 1,
**caractérisé en ce que** :
ladite gravure chimique est effectuée par une dispersion aqueuse de particules de silice contenant un agent mouillant et un ou plusieurs acides organiques chloro-substitués.

3. Procédé selon l'une des revendications 1 ou 2,
**caractérisé en ce que** :
des particules de TiO₂ sont en outre dispersées dans ladite dispersion aqueuse de matériau auto-réticulable.

4. Procédé selon l'une des revendications 1 à 3,
**caractérisé en ce que** :
des pigments sont ajoutés à ladite dispersion aqueuse de matériau auto-réticulable pour obtenir des feuilles protectrices de couleurs différentes.

5. Procédé selon l'une des revendications 1 à 4,
**caractérisé en ce que** :
ladite dispersion aqueuse de matériau auto-réticulable comprend des résines acryliques dispersées dans une solution aqueuse.

6. Procédé selon l'une des revendications 1 à 4,
**caractérisé en ce que** :
ladite dispersion aqueuse de matériau auto-réticulable comprend une dispersion de particules colloïdales de silice.

7. Procédé selon l'une des revendications 1 à 6,
**caractérisé en ce que** :
ledit procédé comprend en outre l'étape de stabilisation thermique de ladite couche de polyester (2) après ladite réaction de réticulation.

8. Procédé selon l'une des revendications 1 à 7,
**caractérisé en ce que** :
ledit procédé comprend en outre :
le dépôt d'une couche adhésive (3) sur la surface de ladite couche de polyester (2) opposée à ladite surface gravée (2a) ;
le collage d'une couche d'apprêt (4) sur ladite couche de polyester (2) par l'intermédiaire de ladite couche adhésive (3).

9. Feuille protectrice, de préférence feuille arrière pour un module photovoltaïque,
**caractérisée en ce que** :
ladite feuille protectrice peut être obtenue par l'un des procédés selon les revendications 1 à 8.

10. Feuille protectrice, de préférence feuille arrière pour un module photovoltaïque,
**caractérisée en ce que** :
ladite feuille protectrice comprend
une couche interne de polyester (2) comprenant une surface gravée (2a) ; et
une couche externe (1) collée sur ladite surface gravée (2a) de ladite couche interne de polyester (2), ladite couche externe (1) comprenant un matériau auto-réticulable réticulé.

11. Module photovoltaïque
**caractérisé en ce que** :
ledit module photovoltaïque comprend une feuille arrière selon l'une des revendications 9 ou 10.
